# EUROPEAN PATENT SPECIFICATION

(11) **EP 3 018 504 B1**
(45) Date of publication and mention of the grant of the patent: **13.05.2020**
(21) Application number: 14820241.9
(22) Date of filing: 25.06.2014
(51) Int. Cl.: G02B 5/02, B32B 9/00, C01B 33/113, C08L 83/08, H01L 31/0216, H01L 31/068, C08K 3/36

(54) **ANTI-GLARE FILM FOR SOLAR CELL MODULE, SOLAR CELL MODULE PROVIDED WITH ANTI-GLARE FILM, AND METHOD FOR MANUFACTURING SAME**
ANTIGLANZFOLIE FÜR EIN SOLARZELLENMODUL, SOLARZELLENMODUL MIT DER ANTIGLANZFOLIE UND VERFAHREN ZUR HERSTELLUNG DAVON
FILM ANTIREFLET POUR MODULE DE PILES PHOTOVOLTAÏQUES, MODULE DE PILES PHOTOVOLTAÏQUES ÉQUIPÉ DU FILM ANTIREFLET ET PROCÉDÉ DE FABRICATION ASSOCIÉ

(30) Priority: 05.07.2013 JP 2013142178
(43) Date of publication of application: 11.05.2016
(73) Proprietor: Kaneka Corporation, Osaka-shi, Osaka 530-8288 (JP)
(72) Inventor: KAWASHIMA, Yoshiyuki, Osaka-shi Osaka 530-8288 (JP); IITSUKA, Naoto, Osaka-shi Osaka 530-8288 (JP); SHIMIZU, Kazuhiro, Osaka-shi Osaka 530-8288 (JP); TAKAHASHI, Takeyoshi, Osaka-shi Osaka 530-8288 (JP)
(74) Representative: Hoffmann Eitle
(86) International application number: PCT/JP2014/066790
(87) International publication number: WO 2015/002042

(56) References cited:
- EP-A1- 2 270 553
- EP-A1- 2 903 031
- JP-A- 2001 053 316
- JP-A- 2001 085 721
- JP-A- 2001 111 072
- JP-A- 2002 120 311
- JP-A- 2003 015 125
- JP-A- 2007 004 339
- JP-A- 2008 156 609
- JP-A- 2009 088 503
- JP-A- 2012 009 600

## Description

### TECHNICAL FIELD

The invention relates to an anti-glare film which is formed on a transparent insulating substrate of a solar cell module, and a solar cell module provided with the anti-glare film. The invention also relates to a method for manufacturing an anti-glare film and a solar cell module provided with the anti-glare film.

### BACKGROUND ART

The use of clean energy has been increasingly encouraged, and the use of solar cells has been accordingly promoted. A solar cell is generally put to practical use as a solar cell module in which an electromotive element (solar cell) composed of a single-crystalline silicon, silicon-based thin-films, a compound semiconductor, or the like is sealed with a resin between a surface cover glass and a back cover film. As a structure intended to reduce the cost of the solar cell module, there has been proposed a substrate-integrated thin-film-based solar cell module obtained by sequentially forming a transparent electrode layer, a semiconductor layer, and a second electrode layer on a transparent insulating substrate, such as glass from a light incident side, while patterning the layers using a laser-scribing method.

In recent years, it has been becoming a common practice to mount a solar cell module on the roof of a house or an outer wall of a building in an urban area, and to use power generation energy therefrom in houses or offices. However, it has been pointed out that, when a solar cell module having glass on a surface on the light incident side is installed on a roof or an outer wall, a problem of light pollution may arise in that reflected light from the solar cell module illuminates the interior of the adjacent house depending on an angle of incidence of sunlight, for example.

Thus, an attempt has been made to suppress the glare by forming an irregular shape on the light incident surface of a glass substrate of a solar cell module to irregularly reflect light, and thereby prevent sunlight from being reflected in the same direction (for example, Patent Document 1). However, for forming an irregular shape on a glass substrate itself, processing at a high temperature or use of a solution with high reactivity, such as hydrofluoric acid, is necessary, and therefore it is difficult to form irregularities after the modularization of a solar cell.

Therefore, when an irregular shape is to be formed on the glass substrate itself, it is necessary that the glass substrate is processed before the modularization. When the glass substrate has an irregularity structure, it is difficult to pattern an electrode layer and a semiconductor layer because laser light is scattered by the glass substrate when a thin-film solar cell is integrated by laser-scribing. Therefore, an anti-glare method which includes formation of an irregular shape on a glass substrate itself is difficult to apply to a thin-film solar cell or the like which is integrated by laser-scribing.

On the other hand, there has been proposed an anti-glare solar cell module in which an irregular-shaped film (hereinafter, referred to as an anti-glare film) containing fine particles in a binder is formed on a surface of a glass substrate (for example, Patent Document 2 and Patent Document 3). These prior art documents propose use of a partially hydrolyzed condensate of an alkyl silicate such as tetraethylorthosilicic acid (TEOS) as a binder. In addition, a film containing fine particles in an acryl-based or urethane-based organic polymer matrix is formed as an anti-glare film on the surface of a display (for example, see Patent Document 4). Patent Document 5, which is prior art under Art. 54(3) EPC, also describes a solar cell module having an anti-glare film that uses non-spherical particles to cause irregular reflection of light thereof.

### PRIOR ART DOCUMENTS

### PATENT DOCUMENTS

Patent Document 1: JP-A-2003-110128
Patent Document 2: JP-A-2001-53316
Patent Document 3: JP-A-11-330508
Patent Document 4: JP-A-2004-4176
Patent Document 5: EP 2903031 A1

### SUMMARY OF THE INVENTION

### PROBLEMS TO BE SOLVED BY THE INVENTION

The method which includes formation of an irregular shape on a glass substrate itself as disclosed in Patent Document 1 has low versatility and is applied only to products on order for public facilities, industrial facilities, and large-scale power generation facilities such as mega solar power plants because it is necessary to subject glass to special processing. On the other hand, in recent years, solar cell modules have been increasingly installed on a surface other than a sunlight-irradiated surface (*e.g*., the north side) for the purpose of increasing an output power, or providing the whole roof with a sense of unity when a roof tile-integrated solar cell module is used, and thus it is urgently necessary to impart an anti-glare property to the solar cell module.

The anti-glare films as disclosed in Patent Documents 2 and 3 can be formed on a substrate after modularization of a solar cell, and are excellent in versatility. However, as a result of studies by the inventors, it has been found that the anti-glare films disclosed in Patent Documents 2 and 3 do not have sufficient film strength and adhesion to the substrate, and are poor in durability when installed outdoors, etc., for a long period of time, and exposed to a high-temperature environment and wind and rain. The anti-glare films in Patent Documents 2 and 3 require heating at a temperature of 100°C or higher at the time of curing a binder to form an anti-glare film. Therefore, when an anti-glare film is formed after modularization of a solar cell, the solar cell provided on a substrate may be thermally degraded by heating for curing.

When a solar cell module is installed outdoors, contaminants such as sand dust and pollen deposited on a light-receiving surface may block off light to reduce the amount of incident light, resulting in deterioration of conversion efficiency. Therefore, it is desirable that in the solar cell module, contaminants on the light-receiving surface be flushed away with rain, etc., for maintaining conversion efficiency in practical use. However, the anti-glare solar cell module has the problem that contaminants easily enter into irregularities on the surface, leading to a reduced ability of removing deposited contaminants.

In view of the above-mentioned problems, an object of the present invention is to provide an anti-glare film for a solar cell module and a solar cell module including the anti-glare film, in which the anti-glare film is excellent in adhesion to a substrate and strength, and also excellent in ability of removing contaminants deposited/attached on a light-receiving surface.

### MEANS FOR SOLVING THE PROBLEMS

As a result of conducting vigorous studies in view of the above-mentioned problems, the inventors have found that the above-mentioned problems can be solved by the following constitutions.

The present invention relates to an anti-glare film for a solar cell module and a method for manufacturing thereof. The anti-glare film according to the present invention is formed on a transparent insulating substrate of a solar cell module and utilized. The anti-glare film includes a first inorganic layer and a second inorganic layer in this order from the substrate-side.

The first inorganic layer includes transparent spherical inorganic fine particles in an inorganic binder. It is preferable that the first inorganic layer is a continuous film having no cracks. The inorganic binder in the first inorganic layer includes as a main component a silicon oxide containing Si-O bonds obtained by hydrolysis of an Si-H bond and an Si-N bond.

The second inorganic layer includes an inorganic binder. Although the inorganic binder in the second inorganic layer is not particularly limited, one including as a main component a silicon oxide containing Si-O bonds obtained by hydrolysis of an Si-H bond and an Si-N bond is preferred.

The first inorganic layer preferably has an average thickness d₁ of 500 to 2000 nm, and the second inorganic layer preferably has an average thickness d₂ of 50 to 1000 nm. The ratio d₂/d₁ between the average thickness of the first inorganic layer and the average thickness of the second inorganic layer is preferably 0.025 to 0.5.

The inorganic fine particles in the first inorganic layer have an average primary particle size of 0.1 to 5.0 µm as calculated from cross-sectional observation of the anti-glare film. The inorganic fine particles in the first inorganic layer are, for example, ones including SiO₂ as a main component.

The first inorganic layer may further include a pigment or dye. When the first inorganic layer includes a pigment or dye, a colored anti-glare film can be obtained.

The anti-glare film of the present invention preferably has a surface maximum height Ry₂ of 1.0 to 10 µm on the second inorganic layer-side. The surface maximum height Ry₂ of the second inorganic layer is preferably smaller than a surface maximum height Ry₁ of the first inorganic layer on an interface with the second inorganic layer.

The anti-glare film of the present invention preferably has a surface arithmetic mean roughness Ra₂ of 0.25 to 2 µm and a roughness period Sm₂ of 1 to 30 µm on the second inorganic layer-side. The ratio Ry₂/d between a total average thickness d of the anti-glare film and a maximum height Ry₂ of the surface on the second inorganic layer-side of the anti-glare film is preferably 1 to 20.

The average refractive index n₂ of the second inorganic layer is preferably lower than the average refractive index n₁ of the first inorganic layer. When n₁ > n₂, the refractive index gradually increases along the light incident direction from the light-receiving-side of the anti-glare film to the substrate-side of the solar cell module. Therefore, reflection at the interface is reduced to increase the amount of light captured in the solar cell module, so that conversion characteristics (particularly a short circuit current density) of the solar cell module can be improved.

For example, the average refractive index n₂ of the second inorganic layer can be reduced when the second inorganic layer further includes inorganic fine particles having a refractive index lower than that of the binder. When the second inorganic layer includes inorganic fine particles, the average primary particle size calculated from a cross-sectional observation of the anti-glare film is preferably 10 to 300 nm. The average primary particle size of the inorganic fine particles in the second inorganic layer is preferably smaller than the average primary particle size of the inorganic fine particles in the first inorganic layer. By reducing the particle size of the fine particles in the second inorganic layer, light incident into the anti-glare film is suppressed from being reflected and scattered at the interface between the binder and the fine particle, so that a loss of incident light is reduced.

The low-refractive-index inorganic fine particles included in the second inorganic layer are, for example, hollow fine particles. Among them, hollow colloidal silica is suitably used.

Preferably, the anti-glare film is formed by a first application step of applying a first coating solution to one principal surface of a transparent insulating substrate; a second application step of applying a second coating solution onto a coated film of the first coating solution; and a curing step of drying solvents in the first coating solution and the second coating solution to cure the coated film. Preferably, both the first application step and the second application step are performed by a spraying method.

As the first coating solution, a solution containing 0.01 to 20% by weight of transparent spherical inorganic fine particles having an average primary particle size of 0.1 to 5.0 µm, 0.1 to 20% by weight of a polysilazane and a solvent is preferably used.

As the second coating solution, one containing 0.1 to 20% by weight of a polysilazane and a solvent is preferably used. The second coating solution may further contain 0.01 to 20% by weight of inorganic fine particles having an average primary particle size of 10 to 300 nm.

Further, the present invention relates to a solar cell module including the anti-glare film. The solar cell module of the present invention includes at least one solar cell on a first principal surface of a transparent insulating substrate, and the anti-glare film on a second principal surface of the transparent insulating substrate.

The solar cell is, for example, a thin-film solar cell. The thin-film solar cell may be integrated. For example, mention is made of an integrated thin-film solar cell module in which a first electrode layer, a photoelectric conversion unit, and a second electrode layer are provided from the transparent insulating substrate-side, these layers are each provided with linear separation grooves to be divided into a plurality of cells, and the plurality of cells are electrically connected to one another in series or in parallel. The solar cell may be a crystalline silicon-based solar cell including a crystalline silicon substrate.

In one embodiment of the solar cell module, the anti-glare film may be patterned. For example, the solar cell module may have on a substrate an anti-glare region on which an anti-glare film is formed and a non-anti-glare region on which the anti-glare film is absent. Such a patterned anti-glare film can be formed by carrying out a covering step of providing a mask material on a part of a surface of the transparent insulating substrate, followed by forming an anti-glare film on a region which is not provided with the mask.

In manufacturing of the solar cell module of the present invention, it is preferable that an anti-glare film forming step of forming an anti-glare film on the second principal surface of the transparent insulating substrate is carried out after a cell forming step of forming a solar cell on the first principal surface of the transparent insulating substrate. For example, after the cell forming step is carried out indoors, the substrate provided with a cell is taken outdoors, and the anti-glare film forming step is carried out outdoors. In this case, formation of the anti-glare film on the second principal surface of the transparent insulating substrate can be performed by a spraying method.

In manufacturing of the thin-film solar cell module, it is preferable that the anti-glare film forming step is carried out after the cell forming step. In the cell forming step, the separation groove is formed by applying laser light from the second principal surface-side of the transparent insulating substrate. According to this method, problems such that laser light is scattered by the anti-glare film do not occur because integration by application of laser light is performed through the substrate before formation of the anti-glare film.

### EFFECTS OF THE INVENTION

According to the present invention, an anti-glare film for a solar cell module is obtained which has a high anti-glare property and which is excellent in film strength and adhesion to a substrate. The anti-glare film according to the present invention is excellent in ability of removing contaminants attached on the surface while having surface irregularities suitable for the anti-glare property. Therefore, even when contaminants are deposited/attached on the light-receiving surface of the solar cell module, the contaminants are easily flushed away with rain, etc., so that deterioration of conversion efficiency in practical use is suppressed.

### BRIEF DESCRIPTION OF THE DRAWINGS

FIG. 1 is a schematic cross sectional view of an anti-glare film according to one embodiment.
FIG. 2 is a schematic cross sectional view of an anti-glare film according to one embodiment.
FIG. 3 is a schematic cross sectional view of a solar cell module provided with an anti-glare film according to one embodiment.
FIG. 4 is a photograph as a substitute for a drawing showing color solar cell modules.
FIG. 5 is a photograph as a substitute for a drawing showing a solar cell module with a patterned anti-glare film
FIG. 6 is SEM images of an anti-glare film of an Example. (a) is a planar image (magnification: 1000X); (b) is a planar image (magnification: 5000X); (c) is a cross-sectional image (magnification: 1000X); and (d) is a cross-sectional image (magnification: 5000X).
FIG. 7 is SEM observation images of an anti-glare film of a Comparative Example. (a) is a planar image (magnification: 1000X); (b) is a planar image (magnification: 5000X); (c) is a cross-sectional image (magnification: 1000X); and (d) is a cross-sectional image (magnification: 5000X).
FIG. 8 is SEM observation images of an anti-glare film of another Comparative Example. (a) is a planar image (magnification: 1000X); (b) is a planar image (magnification: 5000X); and (c) is a cross-sectional image (magnification: 5000X).
FIG. 9 shows photographs showing the results of water-wiping tests for contamination of anti-glare films in the Example and in the Comparative Example.

### MODE FOR CARRYING OUT THE INVENTION

First, an anti-glare film according to the present invention will be described below. In the drawings, dimensional relationships, such as thickness and length, are properly altered as needed for clarity and simplicity of the drawings, and do not correspond to actual dimensions.

### [Configuration of Anti-Glare Film]

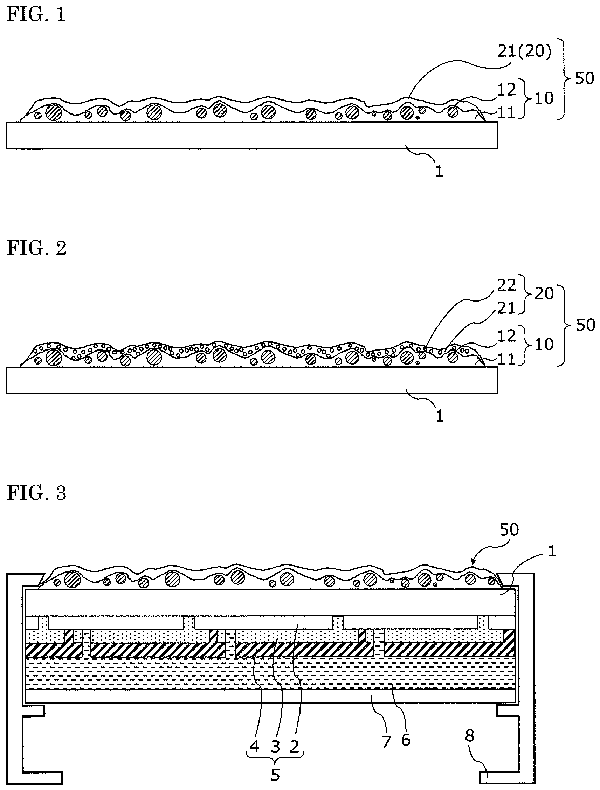

FIG. 1 is a schematic cross-sectional view showing an outline configuration of an anti-glare film for a solar cell module according to one embodiment of the present invention in which an anti-glare film 50 is formed on a transparent insulating substrate 1.

The anti-glare film 50 has surface irregularities. When the anti-glare film 50 having surface irregularities is provided on the light-receiving surface of the transparent insulating substrate 1, sunlight reflected at a surface of the solar cell module is irregularly reflected in indefinite directions. Irregularly reflected scattered light is not in the form of parallel rays but is blurred as a whole, so that light pollution by the reflected light is suppressed.

The anti-glare film 50 includes a first inorganic layer 10 and a second inorganic layer 20 from the transparent insulating substrate 1 side. The first inorganic layer 10 includes inorganic fine particles 12 in an inorganic binder 11. The second inorganic layer 20 includes an inorganic binder 21. Since the first inorganic layer 10 includes inorganic fine particles, random irregularities are formed on a surface of the anti-glare film 50. Therefore, light incident to the solar cell module is irregularly reflected at the light-receiving surface (interface between anti-glare film 50 and air), so that an anti-glare property is exhibited. Since the second inorganic layer 20 is provided on the first inorganic layer 10, the surface shape (level difference in particular) of the first inorganic layer 10 is relaxed. Therefore, entry of contaminants such as sand dust and pollen into the surface irregularity structure of the anti-glare film 50 is suppressed so that the ability of removing contaminants deposited on the light-receiving surface of the solar cell module is improved.

### <First Inorganic Layer>

The first inorganic layer 10 contains transparent inorganic fine particles 12 in an inorganic binder 11.

### (Binder)

As the inorganic binder 11 in the first inorganic layer, a silicon oxide is suitably used, and particularly a silicon oxide containing Si-O bonds obtained by hydrolysis of an Si-H bond and an Si-N bond is suitably used. When the silicon oxide contains Si-O bonds obtained by hydrolysis of an Si-H bond and an Si-N bond, the binder has high transparency, and in addition, the anti-glare film is excellent in its adhesion with a transparent insulating substrate such as glass, light resistance, hardness, and so on.

The inventors formed an anti-glare film using a sol-gel material such as a partially hydrolyzed condensate of an alkyl silicate, as previously proposed, as the binder material of the anti-glare film, and found that the obtained silicon oxide film had a large number of cracks, and was poor in hardness and durability. For this, it was supposed that cracks occurred due to stress on the interface between the transparent insulating substrate (glass plate) and the anti-glare film, which was caused by shrinkage of a material in the formation of silicon oxide by reaction of curing, subsequent influences of heat and moisture, and so on.

When the first inorganic layer 10 includes fine particles 12 having a particle size equivalent to or larger than the average thickness d₁, the first inorganic layer 10 is easily formed with the fine particles 12 partially exposed from the film surface. Thus, when an alkyl silicate or the like is used as a binder material of the anti-glare film, a problem such as peeling and detachment of fine particles from the surface of the anti-glare film occurs if an external force such as a frictional force is applied to the anti-glare film. When the thickness of the first inorganic layer is increased for firmly fixing fine particles in the film, there is the problem in that surface irregularity conforming to the shape of the fine particle is hardly formed, leading to the deterioration of the anti-glare property. Further, since the shape of the interface between the fine particles and the binder is indeterminate, cracks easily occur with the interface as an origination point.

On the other hand, a silicon oxide containing Si-O bonds obtained by hydrolysis of an Si-H bond and an Si-N bond is capable of forming an anti-glare film excellent in friction resistance and free from cracks because fine particles having a large particle size can be firmly fixed in the film.

### (Fine Particles)

As the inorganic fine particles 12 included in the first inorganic layer 10, spherical fine particles are preferably used. When the particles are spherical, projection portions of the film surface are in a curved surface shape, and the ruggedness of irregularities is smoothed, and therefore entry of contaminants such as sand dust and pollen into the irregularity structure of the surface of the anti-glare film is suppressed. A "spherical" fine particle is not necessarily required to be a true sphere, and may be an oblate shape or the like as long as the surface is in a curved shape.

The material of the inorganic fine particle 12 is preferably silicon oxide (SiO₂), titanium oxide (TiO₂), aluminum oxide (Al₂O₃), zirconium oxide (ZrO₂), indium tin oxide (ITO), magnesium fluoride (MgF₂), or the like. For suppressing scattering of light incident into the first inorganic layer to increase the amount of light that arrives at the solar cell, the inorganic fine particle 12 is preferably one formed of a material having a small refractive index difference with respect to the binder 11. Therefore, as the fine particle 12, one having silicon oxide as a main component is most suitably used. For suppressing light scattering in fine particles, the inorganic fine particles 12 in the first inorganic layer are preferably non-hollow fine particles.

The primary average particle size of inorganic fine particles 12 in the first inorganic layer 10 is 0.1 to 5.0 µm, more preferably 0.5 to 4.0 µm, and further preferably 1.0 to 3.0 µm. When the particle size of the inorganic fine particles 12 included in the first inorganic layer 10 falls within the above-mentioned range, surface irregularities suitable for irregular reflection of visible light are formed on the surface of the first inorganic layer 10, and the pattern of the irregularities is transmitted to the surface of the anti-glare film 50. Thus, the anti-glare property of the solar cell module is improved. The primary average particle size of the fine particles is obtained by determining the particle sizes of the particles from a cross-sectional image of the anti-glare film and calculating an average value thereof. The particle size of each particle is defined by a diameter of a circle having an area equivalent to the projected area of the particle (projected area-circle equivalent diameter, Heywood diameter).

The content of inorganic fine particles 12 in the first inorganic layer 10 is preferably 10 to 200 parts by weight, more preferably 20 to 100 parts by weight, and further preferably 40 to 80 parts by weight based on 100 parts by weight of the binder. As the relative content of fine particles 12 to the binder 11 increases, the maximum height Ry₁ of the surface of the first inorganic layer 10 after coating and the ratio Ry₁/d₁ between the thickness d₁ and the maximum height Ry₁ tend to increase. Accordingly, the maximum height Ry₂ of the surface of the second inorganic layer 20 formed thereon tends to increase, leading to improvement of a light scattering property at the surface of the anti-glare film 50. On the other hand, when the relative content of the fine particles 12 is excessively large, the hardness of the first inorganic layer may decrease, or fixation of fine particles may be insufficient.

### (Shape of First Inorganic Layer)

The average thickness d₁ of the first inorganic layer 10 is preferably 500 to 2000 nm, more preferably 750 to 1750 nm, further preferably 1000 to 1500 nm. When the thickness d₁ is 500 nm or more, inorganic fine particles 12 having a primary average particle size of more than 100 nm can be firmly fixed to a surface of the substrate. When the thickness d₁ is 2000 nm or less, irregularities conforming to the shape of the fine particles 12 are formed on the surface of the first inorganic layer 10, and an irregularity pattern conforming thereto is formed on the surface of the anti-glare film 50, so that the anti-glare property of the film is improved. When the first inorganic layer 10 is formed by a coating method, the average thickness d₁ can be calculated from a solid content of a coating solution, a coating amount, and a coating area.

The maximum height Ry₁ of the surface of the first inorganic layer 10 is preferably 1 to 10 µm, more preferably 3 to 8 µm, and further preferably 4 to 6 µm. For obtaining a high anti-glare effect by irregularly reflecting light in a long wavelength range, the arithmetic mean roughness Ra₁ of the surface of the first inorganic layer 10 is preferably 0.25 to 2 µm, more preferably 0.3 to 1.5 µm, more preferably 0.5 to 1.25 µm, and further preferably 0.75 to 1 µm. From a similar viewpoint, the roughness period Sm₁ of the surface of the first inorganic layer 10 is preferably 1 to 30 µm, more preferably 5 to 25 µm, and further preferably 10 to 20 µm.

The roughness period Sm is an average value of the distances between the top-bottom cycles, which are each determined from an intersection point at which a roughness curve, obtained using a laser microscope, crosses an average line. The maximum height Ry is a value represented by a distance between a top line and a bottom line in a cut portion of a roughness curve, where the roughness curve obtained using a laser microscope is cut by a reference (0.8 m) in the direction of an average line to define the cut portion. The maximum height Ry, the arithmetic mean roughness Ra, and the roughness period Sm are measured in accordance with JIS B0601-1994, unless otherwise specified.

The arithmetic mean roughness Ra and the roughness period Sm can be adjusted by changing, for example, the content of the fine particles with respect to the binder, or the particle size of the fine particles. The arithmetic mean roughness Ra tends to increase as the particle size of the fine particles increases, and the roughness period Sm tends to decrease as the content of the fine particles increases.

The ratio Ry₁/d₁ between the thickness d₁ and the maximum height Ry₁ of the first inorganic layer 10 is preferably 1 or more. Ry₁/d₁ being 1 or more indicates that the height difference of the surface irregularities is equal to or more than the average thickness of the first inorganic layer, which means sharply rugged surface irregularities in comparison with the thickness. In the present invention, the first inorganic layer 10 has sharply rugged surface irregularities, and the pattern of the irregularities is transmitted to the surface of the second inorganic layer, so that a high irregular reflection effect is obtained at the surface of the anti-glare film 50. A continuous film, which has fine particles 12 firmly fixed therein and is free from cracks despite having a large surface ruggedness, is obtained by using the binder 11 having as a main component a silicon oxide containing Si-O bonds obtained by hydrolysis of an Si-H bond and an Si-N bond. When Ry₁/d₁ is excessively large, the fixation of fine particles in the anti-glare film tends to be insufficient, leading to a reduction in strength. Thus, Ry₁/d₁ is preferably 1 to 20, more preferably 1.5 to 16, and further preferably 2 to 12.

### (Method for Forming First Inorganic Layer)

Although the method for forming the first inorganic layer 10 on the transparent insulating substrate 1 is not particularly limited, a method is suitable in which a solution containing a silicon oxide binder or a precursor thereof and fine particles is applied onto the transparent insulating substrate 1. Examples of the coating method include a dipping method, a spin coating method, a bar coating method, a die coating method, a roll coating method (printing method), a flow coating method, and a spraying method. Among these coating methods, the spraying method is preferred because special equipment is not required and an anti-glare film can be easily formed on an insulating substrate even after a cell is sealed or after a module is installed on a roof, for example.

As a silicon oxide precursor contained in a coating solution for forming the first inorganic layer 10, a polymer containing Si-H bonds and Si-N bonds is suitably used. The polymer containing Si-H bonds and Si-N bonds is preferably a polysilazane. The polysilazane is a polymer having an Si-N bond (silazane bond) as a basic unit, and is a material that reacts with moisture, for example, in the air, so that Si-H bonds and Si-N bonds are hydrolyzed to be converted into SiO₂. Examples of polysilazane may include perhydropolysilazanes which have no organic group in the molecule and include a repetition of a basic unit represented by -[SiH₂-NH]-, and organopolysilazanes in which hydrogen bonded to silicon and/or nitrogen is partially replaced by an organic group such as an alkyl group. Particularly, for increasing the content of an Si-H bond-derived Si-O bond to obtain an anti-glare film excellent in adhesion and strength, a perhydropolysilazane is suitably used. A mixture of a perhydropolysilazane and an organopolysilazane may be used.

Formation of an Si-O bond by hydrolysis of an Si-H bond can be confirmed by finding that, immediately after the application of a binder material, an Si-H bond-derived peak of around 2160 cm⁻¹ exists in the infrared spectroscopic spectrum, and that the peak decreases and disappears with time, while Si-O bond-derived peaks of around 1060 cm⁻¹, 800 cm⁻¹ and 450 cm⁻¹ appear and grow. Similarly, formation of an Si-O bond by hydrolysis of an Si-N bond can be confirmed by finding that, immediately after the application of a binder material, an Si-N bond-derived peak around 840 cm⁻¹ exists in the infrared spectroscopic spectrum, and that the peak decreases and disappears with time while Si-O bond-derived peaks of around 1060 cm⁻¹, 800 cm⁻¹, and 450 cm⁻¹ appear and grow. When the binder material is a hydrolyzed and cured product of a perhydropolysilazane (-[SiH₂-NH]ₙ-), an N-H bond-derived peak of around 3370 cm⁻¹ further decreases and disappears with time.

As a coating solution to be used for forming the first inorganic layer, a solution containing 0.01 to 20% by weight of inorganic fine particles, 0.1 to 20% by weight of a polysilazane, and a solvent is suitably used. As a solvent, one that dissolves a polysilazane and has an excellent dispersibility of inorganic fine particles is suitably used, and xylene, dibutyl ether, or the like is especially preferably used.

The solid content of polysilazane in the coating solution is preferably 0.1% by weight to 20% by weight, more preferably 1% by weight to 10% by weight, and further preferably 2% by weight to 5% by weight. When the content of the polysilazane falls within the above-mentioned range, the coating solution has a solution viscosity suitable for coating by a spraying method or the like, and an inorganic layer having a thickness of 0.5 µm or more can be stably formed.

The content of inorganic fine particles in the coating solution is preferably 0.01% to 20% by weight, more preferably 0.1% to 10% by weight, and further preferably 1% to 5% by weight. When the content of fine particles in the coating solution falls within the above-mentioned range, fine particles are appropriately dispersed in the polysilazane, so that an anti-glare film excellent in an anti-glare property is easily obtained.

Generally, spherical fine particles having a primary particle size of about 1 µm are aggregated in air or in a solution to form secondary particles. The average secondary particle size of fine particles to be used in the coating solution is preferably 0.1 to 10 µm, more preferably 0.5 to 7.5 µm, and further preferably 1 to 5 µm. The average secondary particle size of the fine particles is measured by a dynamic light scattering method.

Polysilazane has an excellent embedment property in very small gaps, and therefore can penetrate into very small gaps between primary particles, even when the fine particles are aggregated. Thus, the inorganic layer 10 in the form of a continuous film, which is excellent in adhesion between the transparent insulating substrate 1 and the binder 11 and inorganic fine particles 12, and is free from cracks, can be formed.

The coating solution to be used for forming the first inorganic layer 10 may contain components other than a binder, fine particles, and a solvent. For example, a catalyst can be included in the coating solution for curing a polysilazane at normal temperatures to be converted into a silicon oxide.

Examples of the catalyst include N-heterocyclic compounds such as 1-methylpiperazine, 1-methylpiperidine, 4,4'-trimethylenedipiperidine, 4,4'-trimethylene-bis(1-methylpiperidine), diazabicyclo-[2,2,2]octane, cis-2,6-dimethylpiperazine, 4-(4-methylpiperidine)pyridine, pyridine, dipyridine, α-picoline, β-picoline, γ-picoline, piperidine, lutidine, pyrimidine, pyridazine, 4,4'-trimethylenedipyridine, 2-(methylamino)pyridine, pyrazine, quinoline, quinoxaline, triazine, pyrrole, 3-pyrroline, imidazole, triazole, tetrazole, and 1-methylpyrrolidine; amines such as methylamine, dimethylamine, trimethylamine, ethylamine, diethylamine, triethylamine, propylamine, dipropylamine, tripropylamine, butylamine, dibutylamine, tributylamine, pentylamine, dipentylamine, tripentylamine, hexylamine, dihexylamine, trihexylamine, heptylamine, diheptylamine, octylamine, dioctylamine, trioctylamine, phenylamine, diphenylamine, and triphenylamine; DBU (1,8-diazabicyclo[5,4,0]7-undecene), DBN (1,5-diazabicyclo[4,3,0]5-nonene), 1,5,9-triazacyclododecane, and 1,4,7-triazacyclononane. Further, organic acids, inorganic acids, metal carboxylic acid salts, acetylacetonate complexes, and so on are also mentioned as preferred catalysts. Examples of organic acids include acetic acid, propionic acid, butyric acid, valeric acid, maleic acid, and stearic acid, and examples of the inorganic acid include hydrochloric acid, nitric acid, sulfuric acid, phosphoric acid, hydrogen peroxide, chloric acid, and hypochlorous acid. The metal carboxylic acid salt is a compound represented by the formula: (RCOO)ₙM wherein R represents an aliphatic group or cycloaliphatic group with a carbon number of 1 to 22; M represents at least one metal selected from the group consisting of Ni, Ti, Pt, Rh, Co, Fe, Ru, Os, Pd, Ir, and Al; and n represents a valence of M. The metal carboxylic acid salt may be an anhydride or a hydrate. The acetylacetonate complex is a complex in which an anion generated by acid dissociation from acetylacetone (2,4-pentadione) is coordinated with a metal atom. The acetylacetonate complex is generally represented by the formula (CH₃COCHCOCH₃)nM wherein M represents an n-valent metal. Examples of a suitable metal M include nickel, platinum, palladium, aluminum, and rhodium. In addition, organic metal compounds such as peroxides, metal chlorides, ferrocenes, and zirconocenes can be used. The content of the catalyst in the coating solution is preferably about 0.5 to 10 parts by weight based on 100 parts by weight of the polysilazane.

A colored anti-glare film can also be formed by including a pigment or dye in the coating solution for forming the first inorganic layer 10. Although the type of pigment or dye is not particularly limited, the pigment is preferably one that can be properly dispersed in a solvent in the coating solution, and the dye is preferably one that is dissolved in a solvent in the coating solution. For improving the color development, the particle size of the pigment is preferably small, and preferably about 50 to 200 nm. The content of the dye or pigment varies depending on a color to be developed, a type of the dye/pigment, and so on. The content is preferably, for example, about 30 to 60 parts by weight based on 100 parts by weight of the solid of the first inorganic layer.

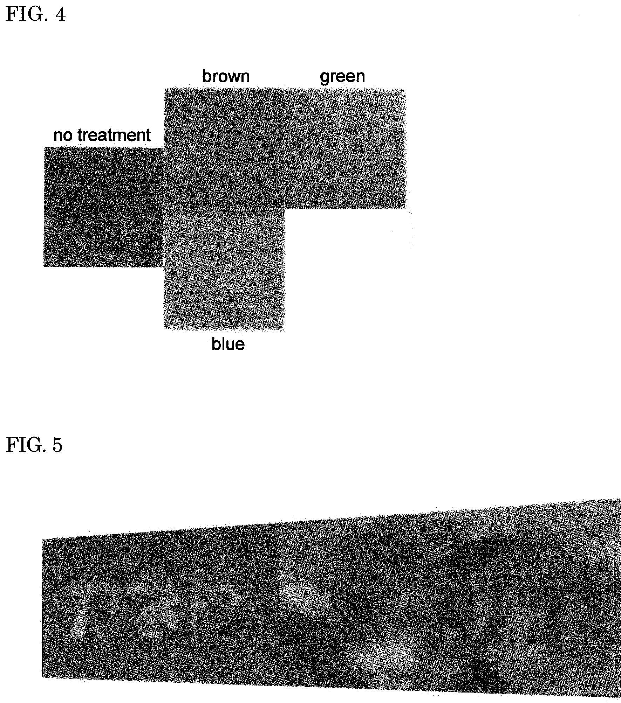

By including a pigment or dye in the first inorganic layer 10 to color the anti-glare film, a color solar cell module as shown in FIG. 4 can be prepared, so that the design property of the module can be improved, and design variations can be expanded. Since the first inorganic layer 10 includes fine particles, color development of the pigment and dye tends to be improved. Thus, by including a pigment or dye in the first inorganic layer to form a colored layer, a colored anti-glare film which is excellent in colorability and develops a clear color is obtained.

As a method for applying a coating solution to the transparent insulating substrate 1, an appropriate method such as a spraying method can be employed as described above. Curing of a polysilazane can proceed even under normal temperatures/normal pressures. Thus, it can be said that the spraying method is a coating method excellent in productivity because a coating solution can be stored in a tightly sealed state until just before use.

The wettability of the surface of the substrate can also be improved by subjecting the surface of the substrate to alkali washing or Cerico washing before applying a coating solution to the transparent insulating substrate 1. Surface treatment of the transparent insulating substrate, etc., may be performed for the purpose of improving adhesion between the transparent insulating substrate 1 and the first inorganic layer. Since a polysilazane is excellent in adhesion (affinity) with glass and has a high embedment property in very small gaps as described above, a pretreatment for improving the wettability of the surface of the substrate can be omitted in the present invention.

An under-layer (not illustrated) may be provided between the transparent insulating substrate 1 and the first inorganic layer 10. For example, adhesion between the transparent insulating substrate 1 and the first inorganic layer 10 can also be improved by forming a polysilazane coated film having a thickness of about 1 to 200 nm by a spraying method before formation of the first inorganic layer. The under-layer may include transparent fine particles having a particle size (*e.g*., a particle size of several tens of nanometers to several hundreds of nanometers) smaller than that of the fine particles 12 in the first inorganic layer 10.

After the coating solution is applied onto the transparent insulating substrate, a solvent in the coating solution is dried, and the polysilazane is cured to form the first inorganic layer. When the anti-glare film 50 is formed after the solar cell 5 is formed on the transparent insulating substrate 1, it is preferred that the drying of a solvent in the coating solution and curing of the polysilazane are each performed at 80°C or lower. When drying and curing are performed at such a low temperature, deterioration of power generation characteristics due to thermal degradation of an amorphous silicon semiconductor, for example, in the solar cell can be inhibited. Particularly, in the present invention, it is preferable that drying and curing are performed under normal temperatures/normal pressures. Particularly, when an anti-glare film is formed outside a factory, *e.g*., at a module installation site, it is preferable that drying and curing are performed under normal temperatures/normal pressures for easily forming an anti-glare film. Normal temperatures/normal pressures refer to an environment where artificial heating and compression/decompression from the outside are not performed, like a usual outdoor environment.

In this way, the first inorganic layer 10 which is excellent in adhesion to the substrate and has a high hardness is formed on the transparent insulating substrate 1. The first inorganic layer 10 is preferably a continuous film having no cracks. The phrase "having no cracks" means that, when five spots are randomly selected from an area of a 10 cm square in the film surface of the anti-glare film, and SEM plane observation is performed at a magnification of 5000X, cracks are not found at any of the observed spots.

### <Second Inorganic Layer>

A second inorganic layer 20 is formed on the first inorganic layer 10. The second inorganic layer 20 contains a binder 21.

### (Binder)

The binder 21 that forms the second inorganic layer 20 is preferably a material excellent in adhesion to the first inorganic layer 10, and an inorganic binder is suitably used. Although the inorganic binder 21 is not particularly limited as long as it has transparency, a silicon-based compound is preferably used. Specific examples of the silicon-based compound include tetraalkyl silicates such as tetramethyl silicate, tetraethyl silicate, tetra-n-propyl silicate, tetra-i-propyl silicate, tetra-n-butyl silicate, tetra-i-butyl silicate, and tetra-t-butyl silicate; and trialkoxysilanes or triaryloxysilanes such as alkyl trialkoxysilanes such as methyl trimethoxysilane, methyl triethoxysilane, octadecyl triethoxysilane, methyl tri-sec-octyloxysilane, methyl triisopropoxysilane, and methyl tributoxysilane; aryl trialkoxysilanes such as phenyl trimethoxysilane and phenyl triethoxysilane; alkyl triaryloxysilanes such as methyl triphenoxysilane, and glycidoxytrialkoxysilanes such as 3-glycidoxypropyltrimethoxysilane.

As the binder 21 in the second inorganic layer 20, a mixture of two or more compounds may be used. The inorganic binder may be a material in which organic molecules are added in an inorganic material binder molecular structure, a material in which inorganic molecules and organic molecules are mixed together, or a material in which an organic binder is dispersed in an inorganic material binder.

The binder 21 in the second inorganic layer 20 is preferably a silicon oxide like the binder 11 in the first inorganic layer 10. When the binder 11 in the first inorganic layer and the binder 21 in the second inorganic layer are made of the same type of materials, adhesion at the interface is improved, and detachment of the fine particles 12 in the first inorganic layer 10 can be prevented, so that a high-strength film is easily obtained.

Preferably, the second inorganic layer 20 is curable at a low temperature, more preferably at a normal temperature/normal pressure, like the first inorganic layer 10. Therefore, the binder 21 in the second inorganic layer is especially preferably a silicon oxide containing Si-O bonds formed by hydrolysis of an Si-H bond and an Si-N bond with a polysilazane used as a precursor material.

### (Shape of Second Inorganic Layer)

The average thickness d₂ of the second inorganic layer 20 is preferably 50 to 1000 nm, more preferably 75 to 750 nm, further preferably 100 to 500 nm. The ratio d₂/d₁ between the average thickness d₁ of the first inorganic layer 10 and the average thickness d₂ of the second inorganic layer 20 is preferably 0.025 to 0.5, more preferably 0.04 to 0.4, further preferably 0.06 to 0.3.

When the thickness d₂ falls within the above-mentioned range, the surface of the second inorganic layer 20, *i.e*., a surface of the anti-glare film 50 on the light-receiving-side maintains the irregular shape pattern of the first inorganic layer 10, and also an abrupt change at the surface of the first inorganic layer 10 is covered with the second inorganic layer 20, and thus relaxed. Therefore, the anti-glare film 50 is obtained which has an anti-glare property resulting from an irregular shape and is excellent in an ability of removing contaminants.

From a similar viewpoint, the ratio between the thickness d₂ of the second inorganic layer 20 to the average primary particle size of the fine particles 12 in the first inorganic layer 10 is preferably 0.025 to 0.8, more preferably 0.04 to 0.7, and further preferably 0.06 to 0.6. When the second inorganic layer 20 is formed by a coating method, the thickness d₂ can be calculated from a solid content of a coating solution, a coating amount, and a coating area.

The maximum height Ry₂ of the surface of the second inorganic layer 20 is preferably 1 to 8 µm, more preferably 1.3 to 7 µm, further preferably 1.5 to 6 µm, especially preferably 1.7 to 4 µm, most preferably 2 to 3 µm. The maximum height Ry₂ of the surface on the second inorganic layer-side is preferably smaller than the maximum height Ry₁ of a surface of the first inorganic layer 10, which is an interface between the first inorganic layer 10 and the second inorganic layer 20.

When the inorganic layer 20 which does not include fine particles or includes fine particles 22 having a small particle size, is formed on the first inorganic layer 10 including fine particles having a particle size of, for example, about 1 µm, the maximum height Ry₂ tends to be smaller than the maximum height Ry₁. The ratio Ry₂/Ry₁ between Ry₁ and Ry₂ is preferably about 0.3 to 0.95, more preferably 0.4 to 0.9, further preferably 0.5 to 0.8. The ratio Ry₂/d between the total average thickness d of the anti-glare film 50 and the maximum height Ry₂ is preferably 0.8 to 10, more preferably 1 to 8, further preferably 1.2 to 6.

For obtaining a high anti-glare effect by irregularly reflecting light in a long wavelength range, the arithmetic mean roughness Ra₂ of the surface of the second inorganic layer 20 is preferably 0.1 to 1.5 µm, more preferably 0.15 to 1.2 µm, further preferably 0.2 to 1 µm, especially preferably 0.25 to 0.8 µm. From a similar viewpoint, the roughness period Sm₂ of the surface of the second inorganic layer 20 is preferably 1 to 30 µm, more preferably 5 to 25 µm, further preferably 10 to 20 µm. When the second inorganic layer 20 is formed on the first inorganic layer 10, the maximum height Ry tends to decrease, while the roughness period Sm tends to be generally retained. Therefore, entry of contaminants into the surface is reduced while the anti-glare film 50 maintains an anti-glare property.

### (Refractive Index of Second Inorganic Layer)

The average refractive index n₂ of the second inorganic layer 20 is preferably smaller than the average refractive index n₁ of the first inorganic layer 10. The difference between n₁ and n₂ is preferably 0.03 or more, more preferably 0.05 or more, further preferably 0.07 or more, especially preferably 0.10 or more. While the average refractive index n₁ of the first inorganic layer 10 mainly composed of silicon oxide is about 1.45 to 1.55, the average refractive index n₂ of the second inorganic layer 20 is preferably 1.45 or less, further preferably 1.40 or less.

When n₁ > n₂, the refractive index gradually increases along the light incident direction from the interface between the anti-glare film and air at the light-receiving-side (refractive index = 1) to the substrate-side of the solar cell module. Therefore, reflection at the interface is reduced to increase the amount of light captured in the solar cell module, so that conversion characteristics (particularly the short circuit current density) of the solar cell module can be improved.

An example of the method for reducing the refractive index n₂ of the second inorganic layer 20 is using a low-refractive-index material as the binder 21. On the other hand, for improving adhesion between the first inorganic layer 10 and the second inorganic layer 20, the binders 11 and 21 included in the former and the latter, respectively, have preferably the same kind or similar kinds of components as described above. Thus, it is preferable that the refractive index of the second inorganic layer is reduced by including in the second inorganic layer 20 inorganic fine particles 22 having a refractive index lower than that of the binder 21 as shown in FIG. 2. The difference between the refractive index of the binder 21 and the refractive index of the fine particle 22 is preferably 0.05 or more, more preferably 0.10 or more, and further preferably 0.13 or more.

### (Fine Particle)

When the second inorganic layer 20 includes the inorganic fine particles 22, the average primary particle size calculated from cross-sectional observation of the anti-glare film is preferably 10 to 300 nm, more preferably 20 to 150 nm, and further preferably 30 nm to 100 nm. For moderating the irregular shape of the surface of the first inorganic layer 10, the average primary particle size of the inorganic fine particles 22 in the second inorganic layer 20 is preferably smaller than the average primary particle size of the inorganic fine particles 12 in the first inorganic layer 10.

When the particle size of the fine particles 22 in the second inorganic layer 20 is 300 nm or less, refraction/reflection/scattering of light at the interface between the binder 21 and the fine particle 22 is suppressed because the particle size is smaller as compared to the main wavelength range of sunlight. Thus, the refractive index of the second inorganic layer 20 is reduced, and a loss of light resulting from the reflection/scattering of light incident to the inside of the anti-glare film 50 is reduced. When the particle size of the fine particles 22 is 10 nm or more, the fine particles 22 can be properly dispersed in the second inorganic layer 20.

The material of the fine particles 22 in the second inorganic layer 20 is not particularly limited as long as the refractive index thereof is lower than that of the binder 21. For example, a metal fluoride such as magnesium fluoride can be used as a material having a low refractive index. As low-refractive-index particles, hollow particles can be used. Hollow particles have a refractive index that lies in between the refractive indexes of their constituent material and air, and are therefore suitable for reducing the refractive index. As hollow particles, hollow silica particles are preferred from the viewpoint of dispersibility in the film and mechanical strength, and particularly hollow colloidal silica particles are suitably used.

When the second inorganic layer 20 includes the fine particles 22, the content thereof is not particularly limited, but is preferably 10 parts by weight or more, more preferably 30 parts by weight or more, and further preferably 40 parts by weight or more based on 100 parts by weight of the binder for achieving a reduction of the refractive index. The upper limit of the content of the fine particles 22 is not particularly limited, but when the relative content of the fine particles 22 is excessively high, the hardness of the second inorganic layer may decrease, or fixation of fine particles may be insufficient. Thus, the content of the fine particles 22 is preferably 300 parts by weight or less, more preferably 200 parts by weight or less, and further preferably 150 parts by weight or less based on 100 parts by weight of the binder.

### (Method for Forming Second Inorganic Layer)

Although the method for forming the second inorganic layer 20 on the first inorganic layer 10 is not particularly limited, a coating method such as a spraying method is preferable as in the case of formation of the first inorganic layer 10.

As the coating solution for forming the second inorganic layer 20, a solution including the binder 21 or a precursor substance thereof, and a solvent for dissolving the same is used. When the second inorganic layer 20 includes the fine particles 22, it is preferable that the fine particles are included in the coating solution. It is preferable that the fine particles 22 are added in the coating solution with the fine particles dispersed in a dispersant for suppressing aggregation of the fine particles. Examples of the dispersant for the fine particles include organic solvents such as methyl ethyl ketone, tetrahydrofuran, dimethyl sulfoxide, ethylene glycol dimethyl ether, diethylene glycol dimethyl ether, ethylene glycol diethyl ether, diethylene glycol diethyl ether and diethylene glycol methyl ethyl ether, and mixtures thereof.

The solid content of the binder or a precursor substance thereof in the coating solution for forming the second inorganic layer 20 is preferably 0.1 to 20% by weight, more preferably 1 to 10% by weight, further preferably 2 to 5% by weight. For example, when the precursor substance of the binder is a polysilazane, the coating solution has a solution viscosity suitable for coating by a spraying method or the like as long as the solid content falls within the above-mentioned range. The content of the inorganic fine particles in the coating solution is appropriately determined according to the content ratio between the binder 21 and the fine particles 22 in the second inorganic layer 20.

In addition to the binder, the fine particles and the solvent, the coating solution to be used for forming the second inorganic layer 20 may contain a catalyst, a pigment, a dye, and the like.

As a method for applying a coating solution onto the first inorganic layer 10, an appropriate method such as a spraying method can be employed as described above. It is preferable that both the first inorganic layer and the second inorganic layer are formed by a spraying method because the first inorganic layer 10 and the second inorganic layer 20 can be successively formed.

The coating solution for the second inorganic layer may be sprayed onto the first inorganic layer either before, during, or after curing of the first inorganic layer. When the first inorganic layer is formed by application of a polysilazane solution, and cured at normal temperature, curing starts immediately after the application, but it takes several days to several weeks until Si-H bonds and Si-N bonds are hydrolyzed and almost all bonds are converted into Si-O bonds. Therefore, for improving productivity of the anti-glare film, it is preferable that application for forming the second inorganic layer is performed before or during curing of the first inorganic layer. When the second inorganic layer is formed on the first inorganic layer by application either before or during curing of the first inorganic layer, curing of the first inorganic layer and curing of the second inorganic layer proceed in parallel. Therefore, adhesion at the interface between the first inorganic layer 10 and the second inorganic layer 20 tends to be improved.

The anti-glare film 50 obtained in this manner irregularly reflects light by means of a random surface irregular shape formed by the fine particles 12 in the first inorganic layer 10, and thus an anti-glare property is exhibited. Further, the surface shape (level difference in particular) of the first inorganic layer 10 is relaxed by the second inorganic layer 20, so that entry of contaminants such as dust and pollen into the irregularity structure of the surface of the anti-glare film 50 is suppressed. The pencil hardness of the anti-glare film 50 by the pencil hardness test (JIS K5600) is preferably 3H or more, more preferably 5H or more, and further preferably 6H or more.

### [Solar Cell Module]

A solar cell module provided with an anti-glare film can be formed by providing the above mentioned anti-glare film on a light-receiving-side surface of a solar cell module. FIG. 3 is a schematic cross-sectional view showing an outline configuration of a solar cell module provided with an anti-glare film according to one embodiment. This solar cell module includes a transparent insulating substrate 1 and a solar cell 5 formed on a first principal surface of the transparent insulating substrate 1, and further includes an anti-glare film 50 on a second principal surface of the transparent insulating substrate.

In the embodiment shown in FIG. 3, the solar cell 5 includes a first electrode layer 2, a photoelectric conversion unit 3, and a second electrode layer 4 from the transparent insulating substrate 1 side. In FIG. 3, the solar cell 5 is divided into a plurality of regions, and the regions are mutually electrically connected in series. In the solar cell module, a filling resin 6 and a back sealing plate 7 are provided on the second electrode layer 4 for protecting the solar cell 5. Further, the solar cell sealed in this way is provided with a frame 8 that is used for holding the transparent insulating substrate 1, the filling resin 6, the back sealing plate 7, and so on, and mounting the solar cell on a pedestal such as a roof. Hereinafter, mainly an embodiment related to the thin-film-based solar cell module shown in FIG. 3 will be described, but the present invention is applicable to various kinds of solar cell modules, such as crystalline silicon-based solar cell modules including a crystalline silicon substrate.

As the transparent insulating substrate 1, a glass plate, a plate-shaped member, or a sheet-shaped member composed of a transparent resin or the like is used. Particularly, the glass plate is preferred because it has a high transmittance and is inexpensive. The solar cell 5 formed on a principal surface of the transparent insulating substrate 1 on a side opposite to a surface, on which the anti-glare film 50 is formed, is not particularly limited, and examples thereof include crystalline silicon-based solar cells including a single-crystalline silicon substrate or a polycrystalline silicon substrate, silicon-based thin-film solar cells including an amorphous silicon thin-film, a crystalline silicon thin-film or the like, compound solar cells such as CIGSs and CISs, organic thin-film solar cells, and dye sensitized solar cells.

For example, in the silicon-based thin-film solar cell, the first electrode layer 2, the photoelectric conversion unit 3, and the second electrode layer 4 are formed in this order on the transparent insulating substrate 1. As a material of the first electrode layer 2, a transparent conductive metal oxide such as ITO, SnO₂ or ZnO is suitably used.

As the photoelectric conversion unit 3, a semiconductor junction obtained by combining a silicon-based semiconductor thin-film of amorphous silicon, amorphous silicon carbide, amorphous silicon germanium, crystalline silicon and the like in a pin type, an nip type, an ni type, a pn type or the like is used. The photoelectric conversion unit 3 may be a tandem type photoelectric conversion unit having a plurality of pn junctions, pin junctions, or the like.

As the second electrode layer 4, a reflecting metal layer of Ag, Al, or the like, a composite layer of a metal layer and a conductive metal oxide layer, or the like is used.

Generally, the solar cell module includes a plurality of solar cells, the solar cells being electrically connected to one another in series or in parallel. Particularly, in the thin-film solar cell, it is preferable that the first electrode layer 2, the photoelectric conversion unit 3, and the second electrode layer 4 are each provided with linear separation grooves, so that the layers are each divided into a plurality of regions to form a plurality of cells, and the cells are electrically connected to one another. For example, FIG. 3 illustrates an embodiment in which three photoelectric conversion cells are connected to one another in series.

Thus, an integrated solar cell with each layer divided into a plurality of cells by separation grooves can be formed by repeating the formation of each layer and the formation of separation grooves by patterning means such as laser-scribing. For example, the integrated solar cell 5 shown in FIG. 3 is manufactured by the following steps.

Separation grooves are formed in the first electrode layer 2 by laser-scribing to divide the first electrode layer 2 in a predetermined pattern, and the photoelectric conversion unit 3 is then formed on the first electrode layer 2. Thereafter, by laser-scribing that causes laser light to enter from the transparent insulating substrate 1 side, separation grooves are formed in the photoelectric conversion unit 3 to divide the photoelectric conversion unit 3 in a predetermined pattern. Thereafter, the second electrode layer is formed on the photoelectric conversion unit 3, and by a laser-scribing that causes laser light to enter from the transparent insulating substrate 1 side, the second electrode layer 4 is blown off together with the photoelectric conversion unit 3 to form separation grooves.

For efficiently forming separation grooves by laser-scribing to integrate the solar cell 5, it is preferred to cause laser light to enter from the transparent insulating substrate 1 side. Here, when the anti-glare film 50 is formed on a surface of the transparent insulating substrate 1 by laser-scribing, problems may occur in the formation of separation grooves, for example, due to the irregular reflection of laser light. Therefore, it is preferred to form an anti-glare film 50 on the transparent insulating substrate 1 after laser-scribing.

It is preferred to provide the filling resin 6 and the back sealing plate 7 on the second electrode layer 4 for protecting the solar cell 5. As the filling resin 6, silicon, ethylene vinyl acetate, polyvinyl butyral, or the like is used, and as the back sealing plate, a fluorine-based resin film, a polyethylene terephthalate film, a metal film of aluminum, for example, a laminate of these films, a film of a multilayer structure, which is formed by stacking a thin-film of SiO₂ to these films, or the like is used.

The anti-glare film 50 is formed on a surface of the transparent insulating substrate 1 on a side opposite to the surface on which the solar cell 5 is formed. The anti-glare film can be formed either before or after formation of the solar cell 5 on the transparent insulating substrate 1. As described above, in the thin-film solar cell module, it is preferable that the anti-glare film 50 is formed after the solar cell 5 is formed and integrated by laser-scribing. The anti-glare film can be formed at any time after laser-scribing, *i.e*., the anti-glare film may be formed immediately after scribing, after performing sealing with the filling resin 6 and the back sealing plate 7, or after installation of the module on a roof, an outer wall, or the like.

After operations up to and including the formation and sealing of a cell are performed indoors, *e.g*., in a factory, a solar cell module before an anti-glare film is formed on a surface of a substrate can be moved to outdoors (*e.g*., the site of a house where the module is installed), followed by forming an anti-glare film before the solar cell module is installed on a roof or the like. According to the above-mentioned method, light pollution can also be prevented by selectively forming an anti-glare film only in a solar cell module installed, for example, in an azimuth opposite to the sunlight-irradiated surface (*e.g*., the north side in the northern hemisphere).

The anti-glare film 50 may be formed on the whole or only a part of a surface of the transparent insulating substrate 1. For example, an anti-glare region, on which an anti-glare film is formed, and a non-anti-glare region, on which an anti-glare film is not formed, can also be formed on the transparent insulating substrate 1. The anti-glare region and non-anti-glare region may be formed into a predetermined patterned shape to form a patterned anti-glare film. For example, a solar cell module with a patterned anti-glare film as shown in FIG. 5 may be formed by providing a mask material, such as a waterproof tape, on a part of a surface of the transparent insulating substrate 1 to cover a surface of a substrate before the formation of an anti-glare film, and selectively forming an anti-glare film on a region which is not provided with the mask. In the left half of the module shown in FIG. 5, an anti-glare film is formed after the character part is covered with a mask material, so that the character part is a non-anti-glare region. In the right half of the module shown in FIG. 5, an anti-glare film is formed after the non-character part is covered with a mask material, so that the character part is an anti-glare region. The shape of the anti-glare region or non-anti-glare region is not particularly limited, and may be a mark, a drawing pattern, a pattern, or the like, as well as a character.

### EXAMPLES

The present invention will be described in more detail below by showing the Examples and Comparative Examples. The scope of the present invention is not limited to the Examples below as long as it does not depart from the scope of the present invention.

### [Example 1]

### (Preparation of Coating Solution)

As a coating solution for forming a first inorganic layer (first coating solution), 2.5 parts by weight of silica beads (manufactured by Admatechs; average primary particle size: 1.2 µm) were added to 20 parts by weight of a polysilazane-containing solution (trade name: "AQUAMICA NAX120-20" manufactured by AZ Electronic Materials Corporation, which contains in dibutyl ether a perhydropolysilazane having a solid content of 20% by weight), and 77.5 parts by weight of dibutyl ether was further added thereto as a solvent to prepare a coating solution. The coating solution contained 62.5 parts by weight of fine particles based on 100 parts by weight of a polysilazane, and had a total solid content of 6.5% by weight.

As a coating solution for forming a second inorganic layer (second coating solution), 80 parts by weight of dibutyl ether as a solvent was added to 20 parts by weight of a polysilazane-containing solution (AQUAMICA NAX120-20) to prepare a coating solution. The solid content of the coating solution was 4.0% by weight.

### (Formation of Anti-Glare Film)

A transparent glass substrate having a thickness of 3.2 mm and a size of 1400 mm × 1100 mm was washed with tap water, freed of water droplets by an air knife, and dried. The first coating solution was applied to one of the surfaces of the dried glass substrate by a spraying method so as to achieve a thickness of 1.0 µm after drying. About 20 seconds after the first coating solution was sprayed (after the surface of the coated film was dried), the second coating solution was applied by a spraying method so as to achieve a thickness of about 300 nm after drying.

This two-layered coated film was dried at room temperature, then left standing at room temperature for 24 hours to cure a binder, thereby forming an anti-glare film having a silicon oxide as a main component. When an infrared spectrum of a binder portion (portion excluding fine particles) of the anti-glare film, after being left standing for 24 hours, was measured by infrared microspectrometry, peaks around 2160 cm⁻¹ (Si-H bond), around 840 cm⁻¹ (Si-N bond), and around 3370 cm⁻¹ (N-H bond) were observed in addition to Si-O bond-derived peaks around 1060 cm⁻¹ , around 800 cm⁻¹, and around 450 cm⁻¹.

When an infrared spectrum was measured again after the glass substrate provided with an anti-glare film was left standing in an outdoor environment for 2 months, peaks around 2160 cm⁻¹, around 840 cm⁻¹, and around 3370 cm⁻¹ disappeared, so that it was confirmed that Si-O bonds were generated by hydrolysis of Si-H bonds and Si-N bonds.

### [Example 2]

In Example 2, an anti-glare film including fine particles in a second inorganic layer was formed. As a second coating solution, 20 parts by weight of a dispersion liquid of hollow colloidal silica (dispersion liquid including colloidal silica with a solid content of 20% by weight (average secondary particle size: 50 nm) in methyl isobutyl ketone) was added to 20 parts by weight of a polysilazane-containing solution (AQUAMICA NAX120-20), and 40 parts by weight of dibutyl ether was further added thereto as a solvent to prepare a coating solution. The coating solution contained 100 parts by weight of fine particles based on 100 parts by weight of a solid of a polysilazane, and had a total solid content of 8.0% by weight.

In the same manner as in Example 1 except that the above-mentioned coating solution including colloidal silica was used as the second coating solution for forming the second inorganic layer, an anti-glare film including a second inorganic layer on a first inorganic layer was formed by a spraying method, the first inorganic layer having an average thickness d₁ of about 1000 nm, the second inorganic layer having an average thickness d₂ of about 300 nm, and including colloidal silica fine particles in the film.

### [Comparative Example 1]

After a first coating solution identical to that used in Example 1 was applied onto a glass substrate by a spraying method, spraying of a second coating solution was not performed, and thus an anti-glare film including only a first inorganic layer was formed.

### [Comparative Example 2]

In preparation of a first coating solution, 1.5 pars by weight of a pulverized glass powder (manufactured by Nippon Frit Co., Ltd.; average secondary particle size: 1.0 µm) was added in place of silica beads. In the same manner as in Example 1 except that the above-mentioned change was made, an anti-glare film including a second inorganic layer on a first inorganic layer was formed by a spraying method, the first inorganic layer having an average thickness d₁ of about 1000 nm, the second inorganic layer having an average thickness d₂ of about 300 nm.

### [Comparative Example 3]

After a first coating solution identical to that used in Comparative Example 2 was applied onto a glass substrate by a spraying method, spraying of a second coating solution was not performed, and thus an anti-glare film including only a first inorganic layer was formed.

### [Evaluation]

### <Anti-Glare Property>

A glass substrate provided with an anti-glare film was irradiated with light from a white fluorescent lamp, and light reflected from the glass substrate was visually observed. The results showed that the anti-glare films of all of the Examples and Comparative Examples were excellent in anti-glare property with the image of the fluorescent lamp looking blurred.

### <Water Wiping Test>

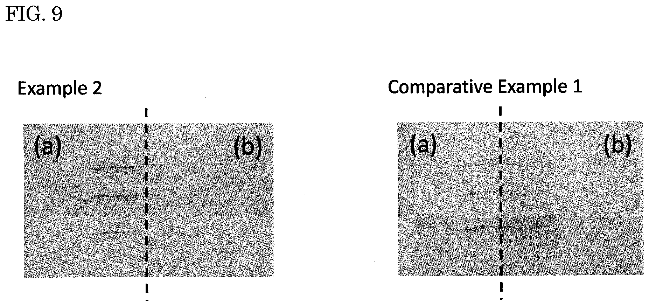

Three lines each having a length of about 5 cm were drawn on the anti-glare film of each of the Examples and Comparative Examples using a pencil with a hardness of 6B, BEMCOT wetted with top water was pressed against the anti-glare film and moved back and forth on the anti-glare film with a fixed pressing force to perform water-wiping, and the number of back-and-forth movements required to erase the penciled stains was examined. In the anti-glare films of both Example 1 and Example 2, the penciled lines were wiped up after five back-and-forth movements. On the other hand, in the anti-glare film of Comparative Example 1, the penciled lines were not completely erased after five back-and-forth movements, and were wiped up after 20 back-and-forth movements. In the anti-glare film of Comparative Example 2, the penciled lines were not completely erased even after 20 back-and-forth movements (erased to a degree comparable to that after five back-and-forth movements in Comparative Example 1), and were almost completely wiped up after about 200 back-and-forth movements. In the anti-glare film of Comparative Example 3, the penciled lines were not completely erased even after 200 back-and-forth movements. FIG. 9 shows photographs where the anti-glare films of Example 2 and Comparative Example 1 were wiped with five back-and-forth movements. In each of the photographs in FIG. 9, a state before wiping is shown on the left side (a) of the glass plate, and a state after wiping with five back-and-forth movements is shown on the right side (b) of the glass plate.

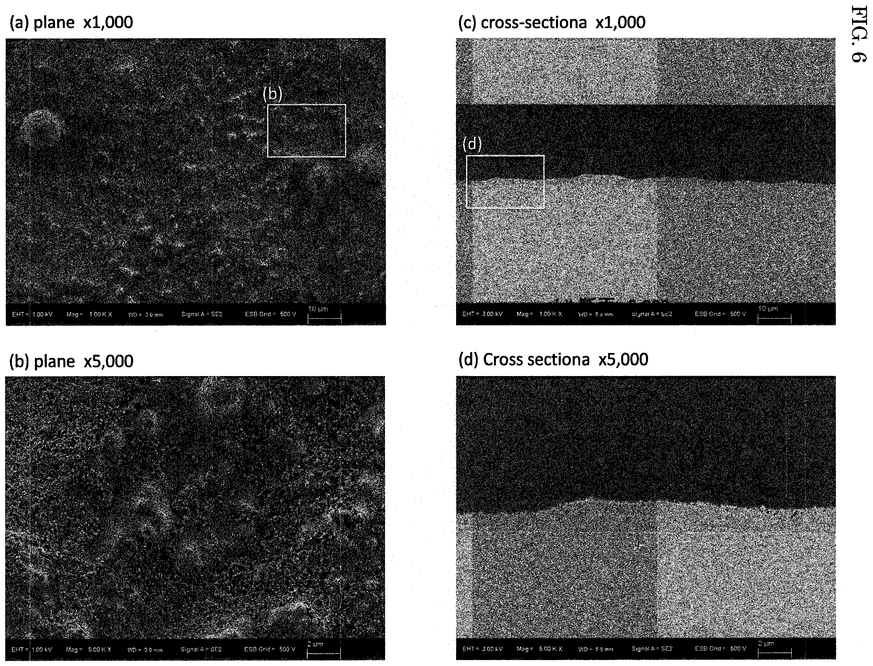

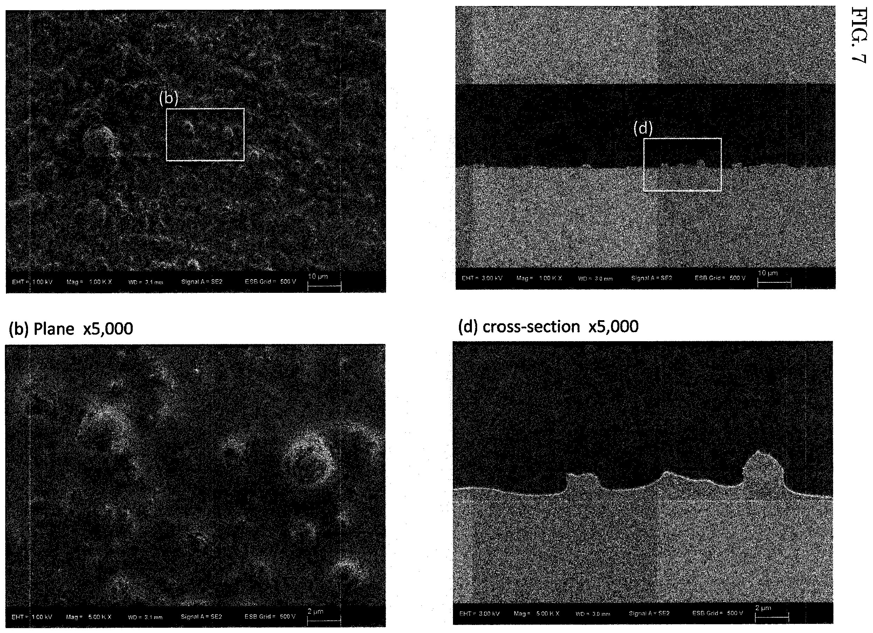

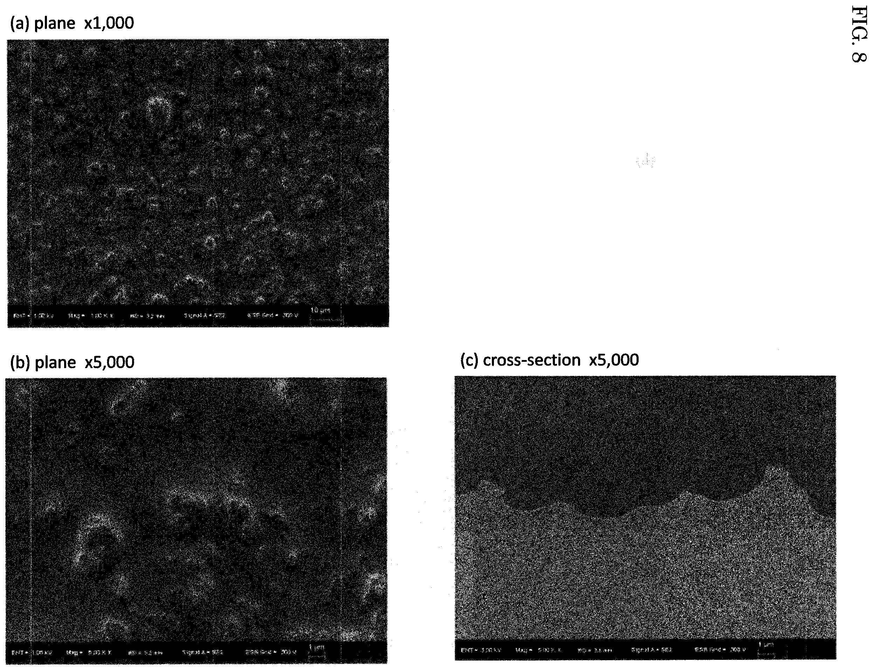

The results of evaluating the anti-glare films obtained in the Examples and Comparative Examples described above are shown in Table 1 together with the compositions of the coating solutions used in each of the Examples. The SEM observation images of the surface and the cross-section of the anti-glare film in Example 2 are shown in FIG. 6, the SEM observation images of the surface and the cross-section of the anti-glare film in Comparative Example 1 are shown in FIG. 7, and the SEM observation images of the surface and the cross-section of the anti-glare film in Comparative Example 2 are shown in FIG. 8. In each of FIG. 6 and FIG. 7, the photograph (b) shows an enlarged observation image of the framed part in the photograph (a), and the photograph (d) shows an enlarged observation image of the framed part in the photograph (c).

**[Table 1]**

| | first layer | | | | second layer | | | | anti-glare film surface shape | | | number of wiping movements |
|---|---|---|---|---|---|---|---|---|---|---|---|---|
| | binder | fine particle | | thickness d₁ (µm) | binder | fine particle | | thickness d₂ (µm) | Ry (µm) | Ra (µm) | Sm (µm) | |
| | material | material | primary particle size (µm) | | material | material | primary particle size (µm) | | | | | |
| Example 1 | polysilazane | silica beads | 1.2 | 1.0 | polysilazane | - | | 0.3 | 2.6 | 0.52 | 15.6 | 5 |
| Example 2 | polysilazane | silica beads | 1.2 | 1.0 | polysilazane | hollow silica | 0.05 | 0.3 | 2.7 | 0.46 | 21.2 | 5 |
| Comparative Example 1 | polysilazane | silica beads | 1.2 | 1.0 | - | | | - | 3.1 | 0.56 | 12.8 | 20 |
| Comparative Example 2 | polysilazane | pulverized glass powder | 1.0 | 1.0 | polysilazane | - | | 0.3 | N.D. | | | 200 |
| Comparative Example 3 | polysilazane | pulverized glass powder | 1.0 | 1.0 | - | | | - | 4.8 | 0.70 | 24.3 | > 200 |

From the plane observation images and the cross-sectional observation images, it is apparent that by using a polysilazane cured product as a binder, a continuous film having no cracks is obtained even when particles having a particle size of about 1 µm are contained. From comparison between FIG. 6(b) and FIG. 7(b), comparison between FIG. 6(d) and FIG. 7(d), and so on, it is apparent that in the anti-glare film of the present invention, the recessed portions of the first inorganic layer are filled with the second inorganic layer while an irregularity pattern resulting from fine particles in the first layer is maintained. Thus, it is considered that in the present invention, the second inorganic layer is formed on the first inorganic layer, and thus contaminants are inhibited from deeply entering into the recessed portions, so that the wiping property is improved.

### <Evaluation of Conversion Characteristics>

A transparent electrode layer, a stacked photoelectric conversion unit including a pin-junction amorphous silicon photoelectric conversion unit and a pin-junction crystalline silicon photoelectric conversion unit, and a metal back electrode were sequentially formed on a glass substrate to prepare an integrated thin-film solar cell module as shown in FIG. 3 (the solar cell module does not include the anti-glare film 50 and is not provided with the frame 8). A total of 20 similar modules were prepared, and the power generation characteristics of the modules were measured using a solar simulator.

After the power characteristics were measured, an anti-glare film was formed on a surface of the glass substrate on a side opposite to the cell-formed surface by the same method as in Example 2 to obtain a solar cell module provided with an anti-glare film. Comparison of the conversion characteristics of the modules before and after formation of the anti-glare film showed that after formation of the anti-glare film, the short circuit current density (Isc) increased by 1.5% to 2.1% (1.8% on average), the open circuit voltage (Voc) increased by 0.1% to 0.3% (0.2% on average), and the maximum power increased by 2.0% to 2.5% (2.2% on average).

From these results, it is apparent that the anti-glare film of the present invention having a two-layered configuration in which a second inorganic layer is provided on a first inorganic layer contributes to improve the ability of removing contaminants. It is also apparent that the anti-reflection effect is improved by inclusion of low-refractive-index fine particles in the second inorganic layer, so that the amount of light taken into a solar cell module is increased and thereby contributes to improve conversion efficiency as well.

### DESCRIPTION OF REFERENCE CHARACTERS

- 10, 20: inorganic layer
- 11, 21: binder
- 12: fine particle (non-hollow fine particle)
- 22: fine particle (hollow fine particle)
- 50: anti-glare film
- 1: transparent insulating substrate
- 2, 4: electrode layer
- 3: photoelectric conversion unit
- 5: solar cell
- 6: filling resin
- 7: back sealing plate
- 8: frame

## Claims

1. A solar cell module comprising: a transparent insulating substrate; at least one solar cell on a first principal surface of the transparent insulating substrate; and an anti-glare film on a second principal surface of the transparent insulating substrate, wherein
the anti-glare film comprises a first inorganic layer and a second inorganic layer, in this order from a substrate-side,
the first inorganic layer contains transparent spherical inorganic fine particles in an inorganic binder, and is a continuous film having no cracks, wherein "spherical" also includes an oblate shape or the like as long as the surface is in a curved shape and wherein the inorganic fine particles in the first inorganic layer have an average primary particle size of 0.1 to 5.0 µm as calculated from a cross-sectional observation of the anti-glare film,
the inorganic binder in the first inorganic layer includes as a main component a silicon oxide containing Si-O bonds obtained by hydrolysis of an Si-H bond and an Si-N bond,
the second inorganic layer includes an inorganic binder and inorganic fine particles having a refractive index lower than a refractive index of the binder in the second inorganic layer,
an average refractive index n₂ of the second inorganic layer is lower than an average refractive index n₁ of the first inorganic layer, and
the first inorganic layer has an average thickness d₁ of 500 nm to 2000 nm, the second inorganic layer has an average thickness d₂ of 50 nm to 1000 nm, and a ratio d₂/d₁ is 0.025 to 0.5.

2. The solar cell module according to claim 1, wherein a surface on a second inorganic layer-side has a surface maximum height Ry₂ of 1.0 to 10 µm as determined by JIS B0601-1994,
preferably wherein the surface maximum height Ry₂ of the surface on the second inorganic layer-side is smaller than a surface maximum height Ry₁ of the first inorganic layer on an interface with the second inorganic layer.

3. The solar cell module according to claim 1 or 2, wherein a surface of the anti-glare film on the second inorganic layer-side has a surface arithmetic mean roughness Ra₂ of 0.25 to 2 µm as determined by JIS B0601-1994, and has a roughness period Sm₂ of 1 to 30 µm as determined by JIS B0601-1994.

4. The solar cell module according to any one of claims 1 to 3, wherein a ratio Ry₂/d between a total average thickness d of the anti-glare film and a maximum height Ry₂ as determined by JIS B0601-1994 of a surface on the second inorganic layer-side of the anti-glare film is 1 to 20.

5. The solar cell module according to any one of claims 1 to 4, wherein the inorganic fine particles in the second inorganic layer have an average primary particle size of 10 nm to 300 nm as calculated from a cross-sectional observation of the anti-glare film, and have smaller average primary particle size than the inorganic fine particles in the first inorganic layer,
preferably wherein the inorganic fine particles in the second inorganic layer are hollow fine particles,
more preferably wherein the inorganic fine particles in the second inorganic layer are hollow colloidal silica.

6. The solar cell module according to any one of claims 1 to 5, wherein the inorganic binder in the second inorganic layer has as a main component a silicon oxide containing Si-O bonds obtained by hydrolysis of an Si-H bond and an Si-N bond.

7. The solar cell module according to any one of claims 1 to 6, wherein the inorganic fine particle in the first inorganic layer includes SiO₂ as a main component.

8. The solar cell module according to any one of claims 1 to 7, wherein the first inorganic layer further includes a pigment or a dye.

9. The solar cell module according to any one of claims 1 to 8, wherein
the at least one solar cell comprises a first electrode layer, a photoelectric conversion unit, and a second electrode layer from a transparent insulating substrate-side,
the first electrode layer, the photoelectric conversion unit, and the second electrode layer are each provided with linear separation grooves and thereby divided into a plurality of cells, and the plurality of cells are electrically connected to one another in series or in parallel.

10. The solar cell module according to any one of claims 1 to 8, wherein the at least one solar cell is a crystalline silicon-based solar cell comprising a crystalline silicon substrate.

11. A method for manufacturing a solar cell module defined in any one of claims 1 to 10, the method comprising formation of an anti-glare film on a second principal surface of a transparent insulating substrate, wherein
formation of the anti-glare film includes: a first application step of applying a first coating solution to the second principal surface of the transparent insulating substrate; a second application step of applying a second coating solution onto a coated film of the first coating solution; and a curing step of drying solvents in the first coating solution and the second coating solution to cure the coated film, wherein
the first coating solution contains 0.01 to 20% by weight of transparent spherical inorganic fine particles, 0.1 to 20% by weight of a polysilazane and a solvent, and
the inorganic fine particles have an average primary particle size of 0.1 to 5.0 µm.

12. The method for manufacturing a solar cell module according to claim 11, wherein the second coating solution contains 0.1 to 20% by weight of a polysilazane and a solvent,
preferably wherein the second coating solution further contains 0.01 to 20% by weight of inorganic fine particles having an average primary particle size of 10 to 300 nm.

13. The method for manufacturing a solar cell module according to claim 11 or 12, wherein each of the first application step and the second application step is performed by a spraying method.

14. The method for manufacturing a solar cell module according to any one of claims 11 to 13, wherein formation of an anti-glare film on the second principal surface of the transparent insulating substrate is carried out after formation of the solar cell on the first principal surface of the transparent insulating substrate,
preferably wherein formation of the solar cell is carried out indoors, the substrate provided with a cell is taken outdoors, the anti-glare film forming step is carried out outdoors, and formation of the anti-glare film is performed by a spraying method.

## Patentansprüche

1. Solarzellenmodul, umfassend: ein transparentes isolierendes Substrat; mindestens eine Solarzelle auf einer ersten Hauptoberfläche des transparenten isolierenden Substrats; und eine Blendschutzfolie auf einer zweiten Hauptoberfläche des transparenten isolierenden Substrats, wobei
die Blendschutzfolie eine erste anorganische Schicht und eine zweite anorganische Schicht umfasst, in dieser Reihenfolge von der Seite des Substrats,
die erste anorganische Schicht transparente kugelförmige anorganische Feinpartikel in einem anorganischen Bindemittel enthält und eine kontinuierliche Folie ist, die keine Risse aufweist, wobei "kugelförmig" auch eine abgeflachte Form oder dergleichen einschließt, so lange die Oberfläche eine gekrümmte Form aufweist, und
wobei die anorganischen Feinpartikel in der ersten anorganischen Schicht eine mittlere Primärpartikelgröße von 0,1 bis 5,0 µm aufweisen, wie aus einer Querschnittsbetrachtung der Blendschutzfolie berechnet,
das anorganische Bindemittel in der ersten anorganischen Schicht als Hauptkomponente ein Siliciumoxid mit Si-O-Bindungen enthält, die durch Hydrolyse einer Si-H-Bindung und einer Si-N-Bindung erhalten wurden,
die zweite anorganische Schicht ein anorganisches Bindemittel und anorganische Feinpartikel mit einem Brechungsindex, der niedriger ist als der Brechungsindex des Bindemittels in der zweiten anorganischen Schicht, enthält,
ein mittlerer Brechungsindex n₂ der zweiten anorganischen Schicht niedriger ist als ein mittlerer Brechungsindex n₁ der ersten anorganischen Schicht, und
die erste anorganische Schicht eine mittlere Dicke d₁ von 500 nm bis 2000 nm aufweist, die zweite anorganische Schicht eine mittlere Dicke d₂ von 50 nm bis 1000 nm aufweist und das Verhältnis d₂/d₁ 0,025 bis 0,5 beträgt.

2. Solarzellenmodul gemäß Anspruch 1, wobei eine Oberfläche auf einer Seite der zweiten anorganischen Schicht eine maximale Oberflächenhöhe Ry₂ von 1,0 bis 10 µm aufweist, wie nach JIS B0601-1994 bestimmt,
vorzugsweise wobei die maximale Oberflächenhöhe Ry₂ der Oberfläche auf der Seite der zweiten anorganischen Schicht kleiner ist als eine maximale Oberflächenhöhe Ry₁ der ersten anorganischen Schicht an der Grenzfläche zur zweiten anorganischen Schicht.

3. Solarzellenmodul gemäß Anspruch 1 oder 2, wobei eine Oberfläche der Blendschutzfolie auf einer Seite der zweiten anorganischen Schicht eine arithmetische mittlere Oberflächenrauheit Ra₂ von 0,25 bis 2 µm, wie nach JIS B0601-1994 bestimmt, und eine Rauheitsperiode Sm₂ von 1 bis 30 µm, wie nach JIS B0601-1994 bestimmt, aufweist.

4. Solarzellenmodul gemäß einem der Ansprüche 1 bis 3, wobei das Verhältnis Ry₂/d zwischen einer mittleren Gesamtdicke d der Blendschutzfolie und einer maximalen Höhe Ry₂, wie nach JIS B0601-1994 bestimmt, einer Oberfläche auf der Seite der zweiten anorganischen Schicht der Blendschutzfolie 1 bis 20 beträgt.

5. Solarzellenmodul gemäß einem der Ansprüche 1 bis 4, wobei die anorganischen Feinpartikel in der zweiten anorganischen Schicht eine mittlere Primärpartikelgröße von 10 nm bis 300 nm, berechnet aus einer Querschnittsbetrachtung der Blendschutzfolie, und eine kleinere mittlere Primärpartikelgröße als die anorganischen Feinpartikel in der ersten anorganischen Schicht aufweisen,
vorzugsweise wobei die anorganischen Feinpartikel in der zweiten anorganischen Schicht hohle Feinpartikel sind,
stärker bevorzugt, wobei die anorganischen Feinpartikel in der zweiten anorganischen Schicht hohles kolloidales Siliciumdioxid sind.

6. Solarzellenmodul gemäß einem der Ansprüche 1 bis 5, wobei das anorganische Bindemittel in der zweiten anorganischen Schicht als Hauptkomponente ein Siliciumoxid mit Si-O-Bindungen aufweist, die durch Hydrolyse einer Si-H-Bindung und einer Si-N-Bindung erhalten wurden.

7. Solarzellenmodul gemäß einem der Ansprüche 1 bis 6, wobei das anorganische Feinpartikel in der ersten anorganischen Schicht SiO₂ als Hauptkomponente enthält.

8. Solarzellenmodul gemäß einem der Ansprüche 1 bis 7, wobei die erste anorganische Schicht ferner ein Pigment oder einen Farbstoff enthält.

9. Solarzellenmodul gemäß einem der Ansprüche 1 bis 8,
wobei die mindestens eine Solarzelle eine erste Elektrodenschicht, eine photoelektrische Umwandlungseinheit und eine zweite Elektrodenschicht umfasst, von der Seite des transparenten isolierenden Substrats aus,
die erste Elektrodenschicht, die photoelektrische Umwandlungseinheit und die zweite Elektrodenschicht jeweils mit linearen Trennrillen versehen sind und dadurch in eine Vielzahl von Zellen unterteilt sind, und die Vielzahl der Zellen elektrisch in Reihe oder parallel miteinander verbunden sind.

10. Solarzellenmodul gemäß einem der Ansprüche 1 bis 8, wobei die mindestens eine Solarzelle eine kristalline Solarzelle auf Siliciumbasis ist, die ein kristallines Siliciumsubstrat umfasst.

11. Verfahren zur Herstellung eines wie einem der Ansprüche 1 bis 10 definierten Solarzellenmoduls, wobei das Verfahren das Bilden einer Blendschutzfolie auf einer zweiten Hauptoberfläche eines transparenten isolierenden Substrats umfasst, wobei
das Bilden der Blendschutzfolie umfasst:
einen ersten Auftragungsschritt, bei dem eine erste Beschichtungslösung auf die zweite Hauptoberfläche des transparenten isolierenden Substrats aufgetragen wird;
einen zweiten Auftragungsschritt, bei dem eine zweite Beschichtungslösung auf den Beschichtungsfilm der ersten Beschichtungslösung aufgetragen wird; und
einen Härtungsschritt, bei dem die Lösungsmittel in der ersten Beschichtungslösung und der zweiten Beschichtungslösung getrocknet werden, um den Beschichtungsfilm zu härten, wobei
die erste Beschichtungslösung 0,01 bis 20 Gew.-% transparente kugelförmige anorganische Feinpartikel, 0,1 bis 20 Gew.-% eines Polysilazans und ein Lösungsmittel enthält, und
die anorganischen Feinpartikel eine mittlere Primärpartikelgröße von 0,1 bis 5,0 µm aufweisen.

12. Verfahren zur Herstellung eines Solarzellenmoduls gemäß Anspruch 11, wobei die zweite Beschichtungslösung 0,1 bis 20 Gew.-% eines Polysilazans und ein Lösungsmittel enthält,
vorzugsweise wobei die zweite Beschichtungslösung ferner 0,01 bis 20 Gew.-% anorganische Feinpartikel mit einer mittleren Primärpartikelgröße von 10 bis 300 nm enthält.

13. Verfahren zur Herstellung eines Solarzellenmoduls gemäß Anspruch 11 oder 12, wobei sowohl der erste als auch der zweite Auftragungsschritt mittels eines Sprühverfahrens durchgeführt wird.

14. Verfahren zur Herstellung eines Solarzellenmoduls gemäß einem der Ansprüche 11 bis 13, wobei das Bilden einer Blendschutzfolie auf der zweiten Hauptoberfläche des transparenten isolierenden Substrats nach dem Bilden der Solarzelle auf der ersten Hauptoberfläche des transparenten isolierenden Substrats durchgeführt wird,
vorzugsweise wobei das Bilden der Solarzelle in einem Innenraum durchgeführt wird, das mit einer Zelle versehene Substrat ins Freie gebracht wird, der Schritt des Bildens der Blendschutzfolie im Freien durchgeführt wird, und das Bilden der Blendschutzfolie mittels eines Sprühverfahrens durchgeführt wird.

## Revendications

1. Module de piles photovoltaïques comprenant: un substrat isolant transparent; au moins une pile photovoltaïque sur une première surface principale du substrat isolant transparent ; et un film antireflet sur une seconde surface principale du substrat isolant transparent, dans lequel
le film antireflet comprend une première couche inorganique et une seconde couche inorganique, dans cet ordre depuis un côté de substrat,
la première couche inorganique contient des particules fines inorganiques sphériques transparentes dans un liant inorganique, et est un film continu ne présentant aucune fissure, dans lequel « sphérique » inclut aussi une forme oblongue ou similaire tant que la surface est dans une forme courbée et dans lequel les particules fines inorganiques dans la première couche inorganique présentent une taille de particules principale moyenne de 0,1 à 5,0 µm comme il est calculé depuis une observation de section transversale du film antireflet,
le liant inorganique dans la première couche inorganique inclut comme un composant principal un oxyde de silicium contenant des liaisons Si-O obtenues par hydrolyse d'une liaison Si-H et une liaison Si-N,
la seconde couche inorganique inclut un liant inorganique et des particules fines inorganiques présentant un indice de réfraction inférieur à un indice de réfraction du liant dans la seconde couche inorganique,
un indice de réfraction n₂ moyen de la seconde couche inorganique est inférieur à un indice de réfraction moyen n₁ de la première couche inorganique, et
la première couche inorganique présente une épaisseur moyenne d₁ de 500 nm à 2 000 nm, la seconde couche inorganique présente une épaisseur moyenne d₂ de 50 nm à 1 000 nm, et un rapport d₂/d₁ est entre 0,025 et 0,5.

2. Module de piles photovoltaïques selon la revendication 1, dans lequel une surface sur un second côté de couche inorganique présente une hauteur maximum de surface Ry₂ de 1,0 à 10 µm comme déterminé par JIS B0601-1994,
de préférence dans lequel la hauteur maximum de surface Ry₂ de la surface sur le second côté de couche inorganique est inférieure à une hauteur maximum de surface Ry₁ de la première couche inorganique sur une interface avec la seconde couche inorganique.

3. Module de piles photovoltaïques selon la revendication 1 ou 2, dans lequel une surface du film antireflet sur le second côté de couche inorganique présente une rugosité moyenne arithmétique de surface Ra₂ de 0,25 à 2 µm comme déterminé par JIS B0601-1994, et présente une période de rugosité Sm₂ de 1 à 30 µm comme déterminé par JIS B0601-1994.

4. Module de piles photovoltaïques selon l'une quelconque des revendications 1 à 3, dans lequel un rapport Ry₂/d entre une épaisseur moyenne totale d du film antireflet et une hauteur maximum Ry₂ comme déterminé par JIS B0601-1994 d'une surface sur le second côté de couche inorganique du film antireflet est de 1 à 20.

5. Module de piles photovoltaïques selon l'une quelconque des revendications 1 à 4, dans lequel les particules fines inorganiques dans la seconde couche inorganique présentent une taille de particule principale moyenne de 10 nm à 300 nm comme calculé depuis une observation de section transversale du film antireflet, et présentent une taille de particules principale moyenne inférieure aux particules fines inorganiques dans la première couche inorganique,
de préférence dans lequel les particules fines inorganiques dans la seconde couche inorganique sont des particules fines creuses,
plus préférentiellement dans lequel les particules fines inorganiques dans la seconde couche inorganique sont de la silice colloïdale creuse.

6. Module de piles photovoltaïques selon l'une quelconque des revendications 1 à 5, dans lequel le liant inorganique dans la seconde couche inorganique présente comme un composant principal un oxyde de silicium contenant des liaisons Si-O obtenues par hydrolyse d'une liaison Si-H et d'une liaison Si-N.

7. Module de piles photovoltaïques selon l'une quelconque des revendications 1 à 6, dans lequel la particule fine inorganique dans la première couche inorganique inclut du SiO₂ comme un composant principal.

8. Module de piles photovoltaïques selon l'une quelconque des revendications 1 à 7, dans lequel la première couche inorganique inclut en outre un pigment ou un colorant.

9. Module de piles photovoltaïques selon l'une quelconque des revendications 1 à 8, dans lequel
l'au moins une pile photovoltaïque comprend une première couche d'électrode, une unité de conversion photoélectrique, et une seconde couche d'électrode d'un côté de substrat isolant transparent,
la première couche d'électrode, l'unité de conversion photoélectrique, et la seconde couche d'électrode sont chacune dotées de rainures de séparation linéaires et divisées ainsi en une pluralité de cellules, et la pluralité de cellules sont électriquement raccordées l'une à l'autre en série ou en parallèle.

10. Module de piles photovoltaïques selon l'une quelconque des revendications 1 à 8, dans lequel l'au moins une pile photovoltaïque est une pile photovoltaïque à base de silicium cristallin comprenant un substrat de silicium cristallin.

11. Procédé de fabrication d'un module de piles photovoltaïques selon l'une quelconque des revendications 1 à 10, le procédé comprenant la formation d'un film antireflet sur une seconde surface principale d'un substrat isolant transparent, dans lequel
la formation du film antireflet inclut : une première étape d'application consistant à appliquer une première solution de revêtement à la seconde surface principale du substrat isolant transparent ; une seconde étape d'application consistant à appliquer une seconde solution de revêtement sur un film revêtu de la première solution de revêtement ; et une étape de cuisson consistant à sécher des solvants dans la première solution de revêtement et la seconde solution de revêtement pour cuire le film revêtu, dans lequel
la première solution de revêtement contient de 0,01 à 20 % en poids de particules fines inorganiques sphériques transparentes, 0,1 à 20 % en poids d'un polysilazane et un solvant, et
les particules fines inorganiques présentent une taille de particules principale moyenne de 0,1 à 5,0 µm.

12. Procédé de fabrication d'un module de piles photovoltaïques selon la revendication 11, dans lequel la seconde solution de revêtement contient de 0,1 à 20 % en poids d'un polysilazane et un solvant,
de préférence dans lequel la seconde solution de revêtement contient en outre de 0,01 à 20 % en poids de particules fines inorganiques présentant une taille de particules principale moyenne de 10 à 300 nm.

13. Procédé de fabrication d'un module de piles photovoltaïques selon la revendication 11 ou 12, dans lequel chacune de la première étape d'application et la seconde étape d'application est réalisée par un procédé de pulvérisation.

14. Procédé de fabrication d'un module de piles photovoltaïques selon l'une quelconque des revendications 11 à 13, dans lequel la formation d'un film antireflet sur la seconde surface principale du substrat isolant transparent est réalisée après la formation de la pile photovoltaïque sur la première surface principale du substrat isolant transparent,
de préférence dans lequel la formation de la pile photovoltaïque est réalisée à l'intérieur, le substrat doté d'une pile est pris à l'extérieur, l'étape de formation de film antireflet est réalisée à l'extérieur, et la formation du film antireflet est réalisée par un procédé de pulvérisation.
